# EUROPEAN PATENT SPECIFICATION

(11) **EP 1 770 470 B1**
(45) Date of publication and mention of the grant of the patent: **20.02.2008**
(21) Application number: 05256142.0
(22) Date of filing: 30.09.2005
(51) Int. Cl.: G05D 23/24

(54) **Improved control panel**
Verbesserte Regeltafel
Panneau de commande amelioré

(43) Date of publication of application: 04.04.2007
(73) Proprietor: Honeywell Control Systems Ltd., Lanarkshire ML1 5SB (GB)
(72) Inventor: Thomson, Ian, Cairnhill Airdrie ML9 9RT (GB); Ferguson, Colin Thomas, Hamilton, ML3 7JY (GB)
(74) Representative: Naismith, Robert Stewart

(56) References cited:
- WO-A-99/12393
- US-A- 3 581 062
- US-A- 3 961 237
- US-B1- 6 347 746

## Description

The present invention relates to an improved control panel and particularly to an improved control panel for a heating system.

Many domestic and office heating systems include wall mounted control panels to permit a user to select a desired air temperature for a room or space. These control panels often include thermistors which monitor the air temperature in the room, or space, and in the event the air temperature has deviated from the user selected temperature, the control panel will instruct the heating system to take appropriate action so that the temperature is returned to the selected value.

The thermistor is generally located on a printed circuit board (PCB) located within the control panel and, conventionally, slots are provided in the control panel housing which permit the passage of the surrounding air into the control panel for monitoring by the thermistor.

Some people, however, find these slots to be unsightly and accordingly, solutions have been sought which allow the thermistor to monitor the surrounding air temperature without the need for slots.

Once such solution is to use a leaded thermistor soldered to the PCB, the thermistor being embedded in a heat sink compound paste, which is in contact with the housing. In such an arrangement, the surrounding air temperature is indicated to the thermistor by the temperature of the housing, heat from which passes through the heat sink compound to the thermistor. There are drawbacks with this arrangement, for example, the leaded thermistor cannot be surface mounted to the PCB with the other components, and needs to be mounted manually to the PCB and bent to an orientation as close to the housing as possible to maximise its sensing effect. Manual mounting of the leaded thermistor to the PCB and the subsequent manipulation adds to the manufacturing cost of the unit. Furthermore, the use of a heat sink compound in the form of a paste is not desirable, as the paste is a nuisance if it gets on the hands or clothes of the unit assembler or the subsequent installer.

A further difficulty in monitoring air temperature arises from the preferred design of some control panels; namely it is desirable, from a cost point of view to have as many of the electronic components, including the thermistor, as possible mounted on the same side of the PCB. During subsequent assembly, the side containing the electronic components, and the thermistor, may face, in use, the wall of the room for which air temperature monitoring is required. This raises a further problem for the designer in that, if cost effective surface mounting of components is to be used, the thermistor will be located on the side of the PCB facing away from the room or space to be monitored.

It is an object of the present invention to obviate or mitigate at least one of the disadvantages associated with the prior art.

According to a first aspect of the present invention there is provided a heating system control panel comprising:
a housing;
a printed circuit board (PCB) located within the housing, the PCB having a first side and a second side;
a heat receiving portion located on the first side of the PCB, the heat receiving portion being in thermal contact with the housing;
a thermistor located on the second side of the PCB; and
at least one thermally conductive path on the PCB connecting the heat receiving portion to the thermistor.

The advantage of such a heating system control panel is such that the thermistor can be a surface mounted thermistor, that is, it can be mounted to the second side of the PCB by the same manufacturing process which is used to mount the other circuitry on the PCB with the consequent reduction in manufacturing cost and time. Utilising at least one thermally conductive path means that the thermistor can be installed on the side of the circuit board intended, when the unit is installed on a wall, to face the wall, as the heat receiving portion is located on the first side of the PCB, the side which faces into the room or space to be monitored. The heat receiving portion will receive less or more heat as the portion of the housing facing into the room fluctuates in response to changes in air temperature. This heat is transmitted along the at least one thermally conductive path to the thermistor which responds accordingly.

Preferably, the thermistor is surface mounted to the PCB.

Preferably, the at least one thermally conductive path passes through the PCB. Having the at least one path passing through the PCB permits the thermistor to be located on the opposite side of the PCB to the heat receiving portion such that the distance between them is minimised. This reduces the opportunity for heat to be lost as it travels along the thermally conductive path.

Preferably, the at least one thermally conductive path passes through at least one via in the PCB. A via is a small hole in the circuit board used to receive components or provide an electrical path through the PCB. Using a via is advantageous, as vias will be included for other purposes on the same PCB and no additional manufacturing steps are required to provide them.

Preferably, the thermistor is mounted between two second surface thermally conductive pads. Preferably, the second surface thermally conductive pads are electrically insulated from each other and are in thermal communication with the at least one thermally conductive path.

Preferably, the heat receiving portion comprises a pair of first surface thermally conductive pads.

Preferably, the first surface thermally conductive pads are electrically insulated from each other.

Preferably, the first and second surface thermally conductive pads are additionally electrically conductive.

Most preferably, the first and second surface thermally conductive pads comprise copper. Alternatively, the 1^{st} and 2^{nd} surface thermally conductive pads comprise any suitable thermally conductive material such as gold, diamond, carbon or silver.

Preferably, the at least one thermally conductive path comprises the same material as the first and second surface thermally conductive pads.

Preferably, the thermally conductive path comprises copper.

Most preferably, where the thermally conductive path passes through at least one via, the thermally conductive path comprises copper plating.

Preferably, the second surface thermally conductive pads are substantially electrically insulated.

Preferably, there is a plurality of thermally conductive paths each passing through a respective via in the PCB.

Preferably, there is at least one first conductive path providing thermal communication between one of the first surface thermally conductive pads and one of the second surface thermally conductive pads and at least one second conductive path providing thermal communication between the other of the first surface thermally conductive pads and the other of the second surface thermally conductive pads.

Preferably, thermal contact between the heat receiving portion and the housing is achieved by a thermally conductive element.

Preferably, the element is a substantially solid material. When the thermistor is surface mounted to the PCB, the distance between the PCB and the housing surface, when the PCB is fixed into position, is constant for each manufactured unit. This permits a solid thermally conductive element to be used which can be compressed between the PCB and the housing. Such an arrangement permits the exclusion of air and improves the flow of heat from the housing to the thermistor.

Preferably, the thermally conductive element is a thermally conductive silicone elastomer with a high thermal conductivity.

According to a second aspect of the present invention there is provided a method of measuring air temperature using a thermistor mounted on a printed circuit board (PCB), the method comprising the steps of:
locating a heating system control panel housing containing the PCB in a body of air the temperature of which is to be measured;
receiving heat response indicative of the air temperature on a heat receiving portion located on a first side of said PCB; and
conducting the received heat along a thermally conductive path on the PCB to a thermistor located on a second side of the PCB.

Preferably, the method includes the step of conducting heat and/or said conductive path through the PCB.

By virtue of the present invention there is provided an improved control panel which permits the air temperature surrounding the control panel to be monitored by a surface mounted thermistor.

These and other aspects of the present invention will now be described by way of example only with reference to the accompanying drawings in which:
Figure 1 is a heating system control panel in an open configuration according to an embodiment of the present invention;
Figure 2 is the control panel of Figure 1 in a closed configuration;
Figure 3 is a schematic top view taken through line A-A on Figure 1 when the control panel is mounted to a wall;
Figure 4 is an enlarged view of a portion of Fig. 5;
Figure 5 is an exploded perspective 3D-view of part of the control panel of Figure 1; and
Figure 6 is an enlarged view of part of Figure 3.

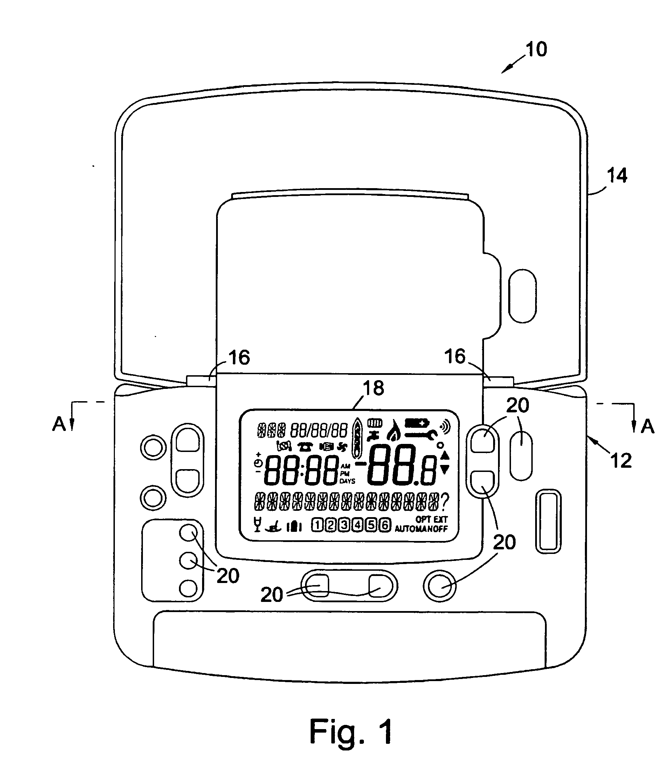

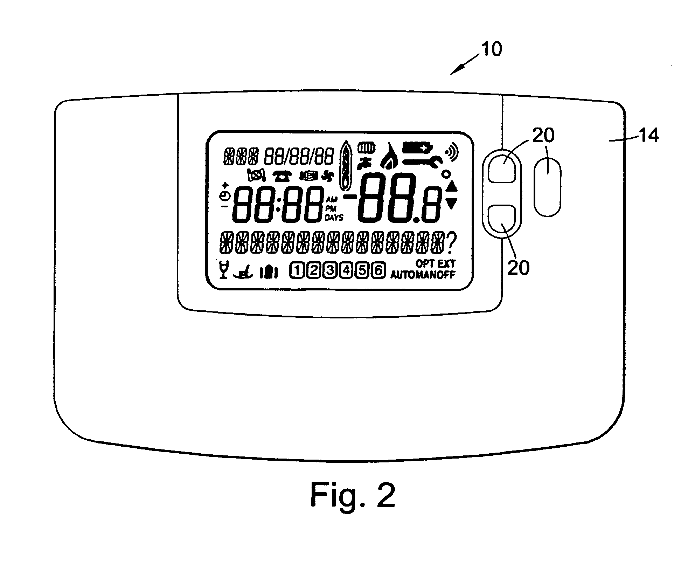

Referring firstly to Figure 1, there is shown a heating system control panel generally indicated by reference numeral 10, in an open configuration according to an embodiment of the present invention. The control panel 10 comprises a housing 12 and a cover 14 fixed to the housing 12 by hinges 16. The cover 14 can rotate about the hinges 16 to the position shown in Figure 2 which shows the control panel 10 of Figure 1 in the closed configuration.

The control panel has a display screen 18 and a number of input buttons 20. If a user wishes to increase the temperature in a room or set a timer to start the heating at a particular time on a particular day, he would lift the cover 14 from the position shown in Figure 2 to the position shown in Figure 1, perform the necessary task using the buttons 20, and close the cover 14 over the buttons 20 again.

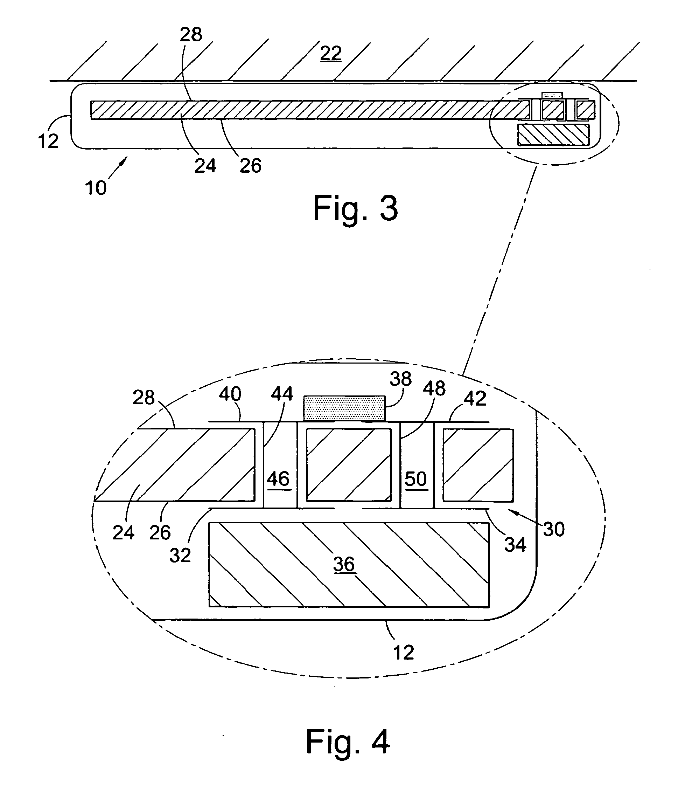

Referring now to Figures 3 and 4, the heating system control panel 10 includes a printed circuit board 24 located within the housing 12, the printed circuit board 24 having a first side, or room side 26 and a second side or wall side 28. Mounted on the room side 26 is a heat receiving portion 30 comprising a first copper heat receiving pad 32 and a second copper heat receiving pad 34. The first and second heat receiving pads 32, 34 are electrically insulated from each other. The first and second heat receiving pads 32, 34 are in thermal contact with the housing 12 by means of a thermally conductive element 36 comprising a piece of thermally conductive silicone elastomer with a high thermal conductivity such as THERMAGON T-flex™ 5130.

On the wall side 28 of the PCB 24, there is mounted a thermistor 38 which is secured to the PCB 24 via first and second thermistor receiving pads 40, 42. The first and second thermistor receiving pads 40, 42 are copper and are also electrically insulated from each other.

Running between the first heat receiving pad 32 and the first thermistor receiving pad 40 is one of seven first thermally conductive paths 44. The first thermally conductive path 44 is in the form of a first copper plated via 46 drilled through the PCB 24. Seven second thermally conductive paths 48, of which only one is shown, are also provided between the second heat receiving pad 34 and the second thermistor receiving pad 42. The second thermally conductive path 48 is also in the form of a second copper plated via 50. Because the first and second heat receiving pads 32, 34 and the first and second thermistor receiving pads 40, 42 are copper, a continuous thermally conductive path is therefore provided from the thermally conductive element 36 and along either of the first or second thermally conductive paths 42, 48 to the thermistor 38.

In use, the housing 12 receives heat from the room representative of the surrounding air temperature. This heat will pass through the silicone elastomer element 36 and along the thermally conductive paths 44, 48 to the thermistor 38. The thermistor 38 resistance varies according to the heat being supplied to it. As is well known, the resistance will vary an electrical current which passes through the thermistor 38 from electrical tracks (not shown) on the PCB 24. Other components on the PCB 24 will interpret the flow of electrical current through the thermistor 38 and relate this to the surrounding air temperature and will issue appropriate instructions to the heating system if necessary.

Although the PCB 24, the thermally conductive element 36 and the housing 12 are shown slightly spaced apart in Figures 3 and 4, in reality the element 36 would be compressed between the housing 12 and the PCB 24 to expel air and maximise the heat transfer.

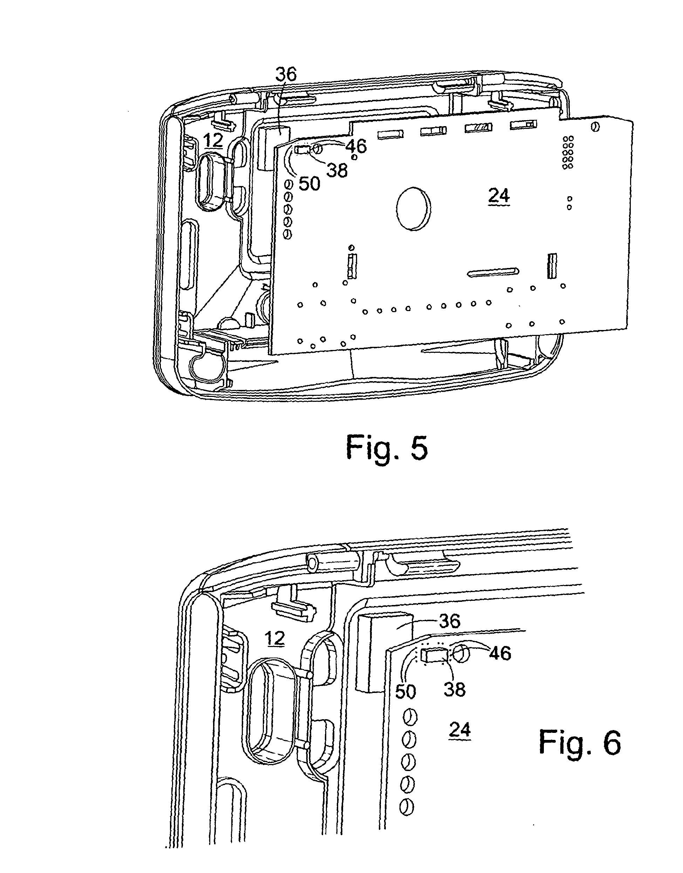

The thermally conductive element 36 can be seen more clearly in Figure 5, an exploded perspective view of part of the control panel 10 of Figure 1 and in Figure 6, an enlarged view of part of Figure 5. As can be seen, the conductive element 36 is a small block of material and is sandwiched between the front of the housing 12 and the PCB 24. Also visible is the thermistor 38, the seven first copper plated vias 46 and the seven second copper plated vias 50.

Various modifications and improvements may be made to the embodiments as previously described without departing from the scope of the invention. For example, although the embodiment utilises copper as the heat transfer material, any suitable material such as gold, diamond, silver or carbon maybe used.

Those of skill in the art will recognise that the above described embodiment of the invention provides a heating system control panel which permits a surface mounted wall facing thermistor to be utilised to monitor the air temperature of a room or space.

## Claims

1. A heating system control panel (10) comprising:
a housing (12);
a printed circuit board (PCB) (24) located within the housing, the PCB having a first side (26) and a second side (28);
a heat receiving portion (30) located on the first side of the PCB, the heat receiving portion being in thermal contact with the housing;
a thermistor (38) located on the second side of the PCB; and
at least one thermally conductive path (44) on the PCB connecting the heat receiving portion to the thermistor.

2. The heating system control panel of claim 1, wherein the thermistor is surface mounted to the PCB.

3. The heating system control panel of either of claims 1 or 2, wherein the at least one thermally conductive path passes through the PCB.

4. The heating system control panel of claim 3, wherein the at least one thermally conductive path passes through at least one via (46) in the PCB.

5. The heating system control panel of any preceding claim, wherein the thermistor is mounted between two second surface thermally conductive pads (90,42), the second surface thermally conductive pads being electrically insulated from each other and being in thermal communication with the at least one thermally conductive path.

6. The heating system control panel of any preceding claim, wherein the heat receiving portion comprises a pair of first surface thermally conductive pads (32,34).

7. The heating system control panel of claim 6, wherein the first surface thermally conductive pads are electrically insulated from each other.

8. The heating system control panel of claim 6 when dependent on claim 5, wherein the first and second surface thermally conductive pads are additionally electrically conductive.

9. The heating system control panel of claim 8 or of claim 6 when dependent on claim 5, wherein the first and second surface thermally conductive pads comprise copper.

10. The heating system control panel of claim 6 when dependent on claim 5, wherein the at least one thermally conductive path comprises the same material as the first and second surface thermally conductive pads.

11. The heating system control panel of any preceding claim, wherein the thermally conductive path comprises copper.

12. The heating system control panel of claim 11, wherein the thermally conductive path passes through at least one via, the thermally conductive path comprises copper plating.

13. The heating system control panel of claim 5, wherein the second surface thermally conductive pads are substantially electrically insulated.

14. The heating system control panel of any preceding claim, wherein there is a plurality of thermally conductive paths.

15. The heating system control panel of claim 14, wherein each thermally conductive path passes through a respective via in the PCB.

16. The heating system control panel of claim 6 when dependent on claim 5, wherein there is at least one first conductive path providing thermal communication between one of the first surface thermally conductive pads and one of the second surface thermally conductive pads and at least one second conductive path providing thermal communication between the other of the first surface thermally conductive pads and the other of the second surface thermally conductive pads.

17. The heating system control panel of any preceding claim, wherein thermal contact between the heat receiving portion and the housing is achieved by a thermally conductive element (36).

18. The heating system control panel of claim 17, wherein the element is a substantially solid material.

19. The heating system control panel of claim 18, wherein the thermally conductive element is a thermally conductive silicone elastomer with a high thermal conductivity.

20. A method of measuring air temperature using a thermistor (38) mounted on a printed circuit board (PCB) (24), the method comprising the steps of:
locating a heating system control panel housing (12) containing the PCB in a body of air the temperature of which is to be measured;
receiving heat response indicative of the air temperature on a heat receiving portion (30) located on a first side (26) of said PCB; and
conducting the received heat along a thermally conductive path (44) on the PCB to a thermistor located on a second side (28) of the PCB.

21. The method of claim 20, wherein the method includes the step of conducting heat and/or said conductive path through the PCB.

## Patentansprüche

1. Heizanlagen-Regeltafel (10), umfassend:
ein Gehäuse (12);
eine Leiterplatte (PCB) (24), innerhalb des Gehäuses angeordnet, wobei die PCB eine erste Seite (26) und eine zweite Seite (28) hat;
ein Wärmeaufnahmeteil (30), auf der ersten Seite der PCB angeordnet, wobei das Wärmeaufnahmeteil mit dem Gehäuse Wärmekontakt hat;
einen Thermistor (38), auf der zweiten Seite der PCB angeordnet; und
mindestens einen wärmeleitenden Pfad (44) auf der PCB, der das Wärmeaufnahmeteil mit dem Thermistor verbindet.

2. Heizanlagen-Regeltafel nach Anspruch 1, worin der Thermistor an die PCB oberflächenmontiert ist.

3. Heizanlagen-Regeltafel nach Anspruch 1 oder 2, worin der mindestens eine wärmeleitende Pfad durch die PCB geht.

4. Heizanlagen-Regeltafel nach Anspruch 3, worin der mindestens eine wärmeleitende Pfad durch mindestens ein Kontaktloch (46) in der PCB geht.

5. Heizanlagen-Regeltafel nach einem vorhergehenden Anspruch, worin der Thermistor zwischen zwei zweite Oberflächen-wärmeleitende Kontaktflecken (40, 42) montiert ist, wobei die zweiten Oberflächen-wärmeleitenden Kontaktflecken voneinander elektrisch isoliert sind und mit dem mindestens einen wärmeleitenden Pfad Wärmekommunikation haben.

6. Heizanlagen-Regeltafel nach einem vorhergehenden Anspruch, worin das Wärmeaufnahmeteil ein Paar erste Oberflächen-wärmeleitende Kontaktflecken (32, 34) aufweist.

7. Heizanlagen-Regeltafel nach Anspruch 6, worin die ersten Oberflächen-wärmeleitenden Kontaktflecken voneinander elektrisch isoliert sind.

8. Heizanlagen-Regeltafel nach Anspruch 6 bei Abhängigkeit von Anspruch 5, worin die ersten und zweiten Oberflächen-wärmeleitenden Kontaktflecken zusätzlich elektrisch leitend sind.

9. Heizanlagen-Regeltafel nach Anspruch 8 oder Anspruch 6 bei Abhängigkeit von Anspruch 5, worin die ersten und zweiten Oberflächen-wärmeleitenden Kontaktflecken Kupfer umfassen.

10. Heizanlagen-Regeltafel nach Anspruch 6 bei Abhängigkeit von Anspruch 5, worin der mindestens eine wärmeleitende Pfad dasselbe Material umfasst wie die ersten und zweiten Oberflächen-wärmeleitenden Kontaktflecken.

11. Heizanlagen-Regeltafel nach einem vorhergehenden Anspruch, worin der wärmeleitende Pfad Kupfer umfasst.

12. Heizanlagen-Regeltafel nach Anspruch 11, worin der wärmeleitende Pfad durch mindestens ein Kontaktloch geht, wobei der wärmeleitende Pfad Verkupferung umfasst.

13. Heizanlagen-Regeltafel nach Anspruch 5, worin die zweiten Oberflächen-wärmeleitenden Kontaktflecken im Wesentlichen elektrisch isoliert sind.

14. Heizanlagen-Regeltafel nach einem vorhergehenden Anspruch, worin es eine Vielzahl von wärmeleitenden Pfaden gibt.

15. Heizanlagen-Regeltafel nach Anspruch 14, worin jeder wärmeleitende Pfad durch ein jeweiliges Kontaktloch in der PCB geht.

16. Heizanlagen-Regeltafel nach Anspruch 6 bei Abhängigkeit von Anspruch 5, worin es mindestens einen ersten wärmeleitenden Pfad gibt, der zwischen einem der ersten Oberflächen-wärmeleitenden Kontaktflecken und einem der zweiten Oberflächen-wärmeleitenden Kontaktflecken Wärmekommunikation bereitstellt, und mindestens einen zweiten wärmeleitenden Pfad, der zwischen dem anderen der ersten Oberflächen-wärmeleitenden Kontaktflecken und dem anderen der zweiten Oberflächen-wärmeleitenden Kontaktflecken Wärmekommunikation bereitstellt.

17. Heizanlagen-Regeltafel nach einem vorhergehenden Anspruch, worin Wärmekontakt zwischen dem Wärmeaufnahmeteil und dem Gehäuse durch ein wärmeleitendes Element (36) erzielt wird.

18. Heizanlagen-Regeltafel nach Anspruch 17, worin das Element im Wesentlichen ein Vollmaterial ist.

19. Heizanlagen-Regeltafel nach Anspruch 18, worin das wärmeleitende Element ein wärmeleitender Silikonelastomer mit hoher Wärmeleitfähigkeit ist.

20. Verfahren zum Messen von Lufttemperatur unter Verwendung eines Thermistors (38), der auf eine Leiterplatte (PCB) (24) montiert ist, wobei das Verfahren folgende Schritte umfasst:
Anordnen eines Heizanlagen-Regeltafelgehäuses (12), das die PCB in einem Luftkörper enthält, dessen Temperatur gemessen werden soll;
Aufnahme der die Lufttemperatur anzeigenden Wärmereaktion auf einem Wärmeaufnahmeteil (30), das auf einer ersten Seite (26) der PCB angeordnet ist; und
Leiten der aufgenommenen Wärme über einen wärmeleitenden Pfad (44) auf der PCB zu einem auf einer zweiten Seite (28) der PCB angeordneten Thermistor.

21. Verfahren nach Anspruch 20, worin des Verfahren den Schritt der Wärmeleitung und/oder den leitenden Pfad durch die PCB enthält.

## Revendications

1. Panneau de commande de système de chauffage (10) comportant
un logement (12) ;
une carte de circuit imprimé (PCB) (24) agencée au sein du logement, la carte de circuit imprimé (PCB) ayant un premier côté (26) et un second côté (28),
une partie de réception de la chaleur (30) agencée sur le premier côté de la carte de circuit imprimé (PCB), la partie de réception de la chaleur étant en contact thermique avec le logement;
une thermistance (38) agencée sur le second côté de la carte de circuit imprimé (PCB) ; et
au moins un trajet thermo-conducteur (44) sur la carte de circuit imprimé (PCB) connectant la partie de réception de la chaleur à la thermistance.

2. Panneau de commande de système de chauffage selon la revendication 1, dans lequel la thermistance est montée en surface sur la carte de circuit imprimé (PCB).

3. Panneau de commande de système de chauffage selon la revendication 1 ou 2, dans lequel ledit au moins un trajet thermo-conducteur traverse la carte de circuit imprimé (PCB).

4. Panneau de commande de système de chauffage selon la revendication 3, dans lequel ledit au moins un trajet thermo-conducteur traverse au moins un trou d'interconnexion (46) dans la carte de circuit imprimé (PCB).

5. Panneau de commande de système de chauffage selon l'une quelconque des revendications précédentes, dans lequel la thermistance est montée entre deux secondes pastilles thermo-conductrices de surface (40, 42), les secondes pastilles thermo-conductrices de surface étant isolées électriquement l'une de l'autre et étant en communication thermique avec ledit au moins un trajet thermo-conducteur.

6. Panneau de commande de système de chauffage selon l'une quelconque des revendications précédentes, dans lequel la partie de réception de la chaleur comporte une paire de premières pastilles thermo-conductrices de surface (32, 34).

7. Panneau de commande de système de chauffage selon la revendication 6, dans lequel les premières pastilles thermo-conductrices de surface sont isolées électriquement l'une de l'autre.

8. Panneau de commande de système de chauffage selon la revendication 6, lorsque celle-ci est dépendante de la revendication 5, dans lequel les premières et secondes pastilles thermo-conductrices de surface sont en outre électro-conductrices.

9. Panneau de commande de système de chauffage selon la revendication 8 ou selon la revendication 6 lorsque celle-ci est dépendante de la revendication 5, dans lequel les premières et secondes pastilles thermo-conductrices de surface comportent du cuivre.

10. Panneau de commande de système de chauffage selon la revendication 6, lorsque celle-ci est dépendante de la revendication 5, dans lequel ledit au moins un trajet thermo-conducteur comporte le même matériau que les premières et secondes pastilles thermo-conductrices de surface.

11. Panneau de commande de système de chauffage selon l'une quelconque des revendications précédentes, dans lequel le trajet thermo-conducteur comporte du cuivre.

12. Panneau de commande de système de chauffage selon la revendication 11, dans lequel le trajet thermo-conducteur traverse au moins un trou d'interconnexion, le trajet thermo-conducteur comporte un cuivrage.

13. Panneau de commande de système de chauffage selon la revendication 5, dans lequel les secondes pastilles thermo-conductrices de surface sont considérablement isolées électriquement.

14. Panneau de commande de système de chauffage selon l'une quelconque des revendications précédentes, dans lequel il existe une pluralité de trajets thermo-conducteurs.

15. Panneau de commande de système de chauffage selon la revendication 14, dans lequel chaque trajet thermo-conducteur traverse un trou d'interconnexion respectif dans la carte de circuit imprimé (PCB).

16. Panneau de commande de système de chauffage selon la revendication 6, lorsque celle-ci est dépendante de la revendication 5, dans lequel il existe au moins un premier trajet thermo-conducteur délivrant une communication thermique entre l'une des premières pastilles thermo-conductrices de surface et l'une des secondes pastilles thermo-conductrices de surface et au moins un second trajet thermo-conducteur délivrant une communication thermique entre l'autre des premières pastilles thermo-conductrices de surface, et l'autre des secondes pastilles thermo-conductrices de surface.

17. Panneau de commande de système de chauffage selon l'une quelconque des revendications précédentes, dans lequel un contact thermique entre la partie de réception de la chaleur et le logement est obtenu par un élément thermo-conducteur (36).

18. Panneau de commande de système de chauffage selon la revendication 17, dans lequel l'élément est un matériau considérablement solide.

19. Panneau de commande de système de chauffage selon la revendication 18, dans lequel l'élément thermo-conducteur est un élastomère de silicone thermo-conducteur ayant une conductivité thermique élevée.

20. Procédé destiné à mesurer la température de l'air au moyen d'une thermistance (38) montée sur une carte de circuit imprimé (PCB) (24), le procédé comportant les étapes consistant à :
agencer un logement de panneau de commande de système de chauffage (12) contenant la carte de circuit imprimé (PCB) dans un corps d'air dont la température doit être mesurée ;
recevoir une réponse thermique indicative de la température de l'air sur une partie de réception de la chaleur (30) agencée sur un premier côté (26) de ladite carte de circuit imprimé (PCB) ; et
diriger la chaleur reçue le long d'un trajet thermo-conducteur (44) sur la carte de circuit imprimé (PCB) vers une thermistance agencée sur un second côté (28) de la carte de circuit imprimé (PCB).

21. Procédé selon la revendication 20, dans lequel le procédé comporte l'étape consistant à diriger la chaleur et/ou ledit trajet thermo-conducteur à travers la carte de circuit imprimé (PCB).
